# EUROPEAN PATENT APPLICATION

(11) **EP 3 573 433 A1**
(43) Date of publication of application: **27.11.2019**
(21) Application number: 19175492.8
(22) Date of filing: 20.05.2019
(51) Int. Cl.: H05B 37/02, H01S 5/068, A61B 3/12

(54) **LIGHT EMISSION DRIVING DEVICE AND DRIVING METHOD THEREOF**

(30) Priority: 21.05.2018 JP 2018097012
(71) Applicant: STANLEY ELECTRIC CO., LTD., Tokyo 153-8636 (JP)
(72) Inventor: NISHIOKA, Ken, Tokyo, 153-8636 (JP)
(74) Representative: Emde, Eric

(57) **Abstract**

In a light emission driving device (1), a high speed APC circuit (11) has a time constant τ1 to reach a target light intensity and a low speed APC circuit (13) has a time constant τ2 larger than the time constant τ1 to reach the target light intensity. A control unit (9) of the light emission driving device (1) uses the high speed APC circuit (11) at the time of startup of the light emission driving device (1), and when a predetermined time has passed after the light intensity of laser light has reached the target light intensity, switches to the low speed APC circuit (13) and supplies an initial signal causing the low speed APC circuit (13) to output a driving signal corresponding to the target light intensity.

## Description

### BACKGROUND OF THE INVENTION

### 1. Field of the Invention

The present invention relates to a light emission driving device of a light emitting unit such as a laser diode, and to a driving method thereof.

### 2. Description of the Related Art

Conventionally, equipment such as a fundus camera has employed a laser diode as a light source and has controlled an amount of light by using an APC (Auto Power Control) circuit. More specifically, a light detector such as a photodiode detects the output of the laser diode and a control unit controls a driving current of the laser diode so that an amount of received light becomes constant.

For example, an LD driving circuit disclosed in the following Japanese Patent Application Laid-Open No. 2009-043784 is a circuit configured to supply a driving current to an LD (laser diode) and includes an LD driver, a monitor PD (photodiode), a current control circuit, and a temperature sensing element.

The current control circuit is a circuit for controlling a driving current in the LD driver. The current control circuit inputs a light intensity signal output from the monitor PD and controls a driving current in the LD driver so that the average light intensity and extinction ratio of a signal light indicated by the light intensity signal are maintained at predetermined levels.

Moreover, the current control circuit controls the driving current to a constant value regardless of the light intensity signal when the driving current reaches or exceeds a certain determination threshold due to an abnormality etc. occurring in the monitor PD (JP P2009-043784A).

However, when a detection signal cannot be acquired due to an abnormality occurring in the monitor PD, for example, the LD driving circuit disclosed in JP P2009-043784A may determine that the LD does not emit light or the output is lower than a target value even if the LD is normally emitting light.

In this case, because the current control circuit increases the driving current to raise the output of the LD, the current control circuit may consequently increase the driving current up to a level where the LD breaks down. Therefore, in case of medical equipment etc., an amount of light that may adversely affect a human body may be emitted.

The present invention has been made in view of such circumstances, and an object of the invention is to provide a light emission driving device having high safety and a driving method thereof.

### SUMMARY OF THE INVENTION

A light emission driving device according to the present invention includes: a light emitting unit; a driving current generating unit configured to supply a driving current according to a driving signal to the light emitting unit; a light detecting unit configured to detect emitted light from the light emitting unit; a first automatic light output control circuit and a second automatic light output control circuit configured to adjust the driving signal to the driving current generating unit in accordance with a detection light intensity of the light detecting unit and to control an intensity of the emitted light to a predetermined target light intensity; a switch circuit configured to switch between the first automatic light output control circuit and the second automatic light output control circuit in response to a switching signal; and a control unit configured to instruct the first automatic light output control circuit and the second automatic light output control circuit on the target light intensity, wherein the first automatic light output control circuit has a first time constant to reach the target light intensity, the second automatic light output control circuit has a second time constant larger than the first time constant to reach the target light intensity, and the control unit: outputs to the switch circuit the switching signal designating the first automatic light output control circuit at startup; and when a predetermined time has passed after the intensity of the emitted light has reached the target light intensity, supplies to the switch circuit the switching signal designating the second automatic light output control circuit and supplies an initial signal causing the second automatic light output control circuit to output the driving signal corresponding to the target light intensity.

The light emission driving device according to the present invention includes the first automatic light output control circuit that has the first time constant to reach the target light intensity and the second automatic light output control circuit that has the second time constant larger than the first time constant. Because the control unit designates the first automatic light output control circuit by the switch circuit at device startup, the control unit can accelerate the start of use of the device by causing the intensity of the emitted light to quickly reach the target light intensity.

Moreover, the control unit designates the second automatic light output control circuit by using the switch circuit after the predetermined time has passed since the intensity of the emitted light has reached the target light intensity. At this time, because the control unit supplies the initial signal causing the second automatic light output control circuit to output the driving signal corresponding to the target light intensity, it is possible to cause the second automatic light output control circuit to quickly reach the target light intensity.

After switching to the control by the second automatic light output control circuit, the intensity of the emitted light is only slowly raised even when the control to raise the emitted light is performed due to an abnormality occurring in the light detecting unit. For this reason, the emitted light that may adversely affect a human body does not leak out to the outside and thus the light emission driving device having high safety can be obtained.

In the light emission driving device according to the present invention, it is preferable that the light emission driving device further includes: a shielding unit configured to block the emitted light; and a shielding drive unit configured to drive the shielding unit by being controlled by the control unit, wherein the control unit supplies a shielding-unit driving signal to drive the shielding unit to the shielding drive unit when the detection light intensity of the light detecting unit is equal to or more than an abnormal light intensity higher than the target light intensity.

Because the control unit supplies the shielding-unit driving signal to the shielding drive unit when the detection light intensity of the light detecting unit is equal to or more than the abnormal light intensity, the shielding unit blocks the emitted light of the light emitting unit. As a result, because the light of the abnormal intensity is prevented from leaking out to the outside, the safety of the light emission driving device can be further enhanced.

Moreover, in the light emission driving device according to the present invention, it is preferable that the light emission driving device includes a switch circuit as the circuit switching unit, and the control unit supplies the switching signal to the switch circuit when switching between the first automatic light output control circuit and the second automatic light output control circuit.

According to this configuration, the control unit supplies the switching signal to the switch circuit to switch between the first automatic light output control circuit and the second automatic light output control circuit. As a result, the device that can switch between two light output control circuits can be implemented with a simple configuration.

Moreover, in the light emission driving device according to the present invention, it is preferable that the control unit supplies the switching signal designating the first automatic light output control circuit to the switch circuit in response to a change signal to change the target light intensity after the predetermined time has passed.

After the predetermined time has passed since the intensity of the emitted light has reached the target light intensity, the driving current of the laser diode is generated by the second automatic light output control circuit. According to the configuration of the present invention, when changing the target light intensity, the control unit supplies the switching signal designating the first automatic light output control circuit to the switch circuit to switch to the first automatic light output control circuit from the second automatic light output control circuit. As a result, the device can be used after quickly switching to a new target light intensity.

A driving method of a light emission driving device according to the present invention, which includes a light emitting unit, a light detecting unit configured to detect emitted light from the light emitting unit, and a drive control unit configured to adjust a driving signal to drive the light emitting unit in accordance with a detection light intensity of the light detecting unit and to control an intensity of the emitted light to a predetermined target light intensity, includes: a first automatic light output control step of controlling the intensity of the emitted light to the target light intensity by using a first time constant; and a second automatic light output control step of controlling the intensity of the emitted light to the target light intensity by using a second time constant larger than the first time constant after the first automatic light output control step, wherein the second automatic light output control step starts driving from a light intensity corresponding to the target light intensity.

In the driving method of the light emission driving device according to the present invention, because the intensity of the emitted light is controlled to the target light intensity in the first automatic light output control step of the first time constant, the start of use of the device can be accelerated by causing the intensity of the emitted light to comparatively quickly reach the target light intensity.

In the second automatic light output control step after the first automatic light output control step, the intensity of the emitted light is controlled to the target light intensity by using the second time constant larger than the first time constant. Because the second automatic light output control step reaches the target light intensity slower than the first automatic light output control step, the second automatic light output control step starts driving from the light intensity corresponding to the target light intensity. As a result, the intensity of the emitted light can be made to quickly reach the target light intensity.

Also after that, the intensity of the emitted light is controlled to the target light intensity by using the second time constant. Herein, the control to raise the emitted light may be performed due to an abnormality occurring in the light detecting unit, but the intensity of the emitted light is only slowly raised. For this reason, the emitted light that may adversely affect the human body does not leak out to the outside and thus the light emission driving device can be safely driven.

In the driving method of the light emission driving device according to the present invention, it is preferable that the driving method further includes a switching step of performing the first automatic light output control step in response to a change signal to change the target light intensity.

When changing the target light intensity, the first automatic light output control step is performed by the switching step. As a result, the device can be used after quickly switching to a new target light intensity.

### BRIEF DESCRIPTION OF THE DRAWINGS

FIG. 1 is an entire configuration diagram illustrating a light emission driving device according to an embodiment of the present invention;
FIG. 2 is a diagram explaining circuit response characteristics of a high speed APC circuit and a low speed APC circuit; and
FIG. 3 is a diagram explaining abnormal stop processing when an abnormality occurs in a photodiode.

### DESCRIPTION OF THE PREFERRED EMBODIMENTS

Hereinafter, an exemplary embodiment of a light emission driving device according to the present invention will be explained with reference to the drawings.

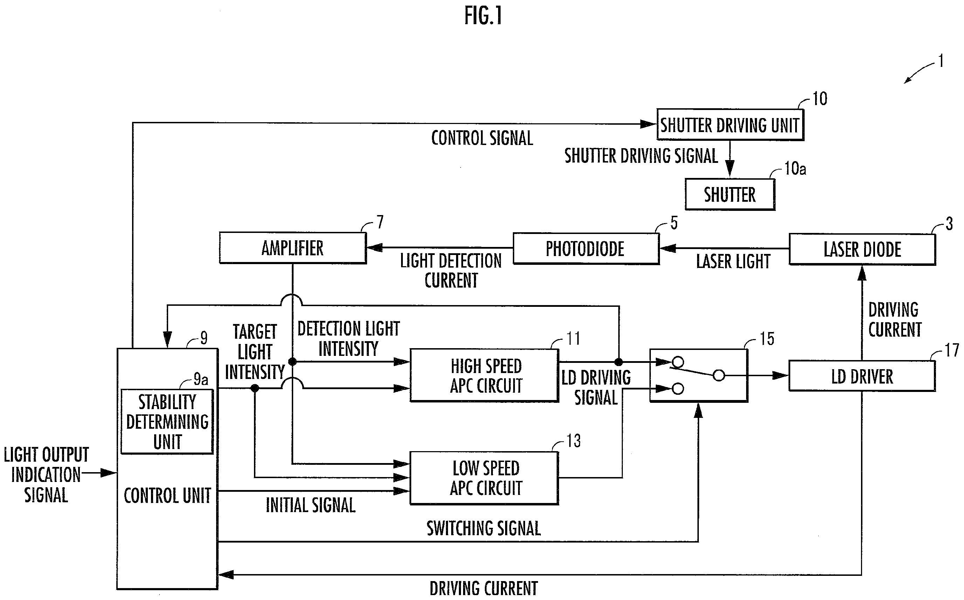

First, the configuration of a light emission driving device 1 according to the embodiment will be explained with reference to FIG. 1. A laser diode 3 ("light emitting unit" of the present invention) is a semiconductor light emitting element that changes an amount of light in accordance with a driving current from an LD driver 17 to be described later. A wavelength varies depending on application, but a fundus camera uses wavelengths of red (wavelength: approximately 630 nm) and green (wavelength: approximately 530 nm).

A photodiode 5 ("light detecting unit" of the present invention) receives laser light (light detection signal) emitted from the laser diode 3 and generates a light detection current according to its light intensity. Then, the photodiode supplies the light detection current to an amplifier 7 to be described later.

The amplifier 7 converts the light detection current from the photodiode 5 into a voltage at a constant rate and supplies the voltage as a detection light intensity to a high speed APC circuit 11 and a low speed APC circuit 13 to be described later. As an example, the amplifier 7 can include a TIA (Trans Impedance Amplifier).

A control unit 9 supplies a target light intensity to the high speed APC circuit 11 and the low speed APC circuit 13 in accordance with the input light output indication signal. The light output indication signal is a laser emission enable signal and a light output intensity signal. Moreover, the control unit 9 supplies a switch signal to instruct switching between the high speed APC circuit 11 and the low speed APC circuit 13 to a switch circuit 15 to be described later.

A stability determining unit 9a of the control unit 9 checks whether the output of the high speed APC circuit 11 is stabilized based on a feedback signal from the high speed APC circuit 11. The details will be described later, but the control unit 9 outputs a switch signal to instruct switching from the high speed APC circuit 11 to the low speed APC circuit 13 when the output of the high speed APC circuit 11 is stabilized at the target light intensity and a predetermined time passes.

Moreover, the control unit 9 also receives a feedback signal from the LD driver 17 to be described later. The stability determining unit 9a determines an abnormality when the change amount of a driving current per unit time is equal to or more than a predetermined value in a stable state. The control unit 9 can detect an abnormality before reaching an abnormal light intensity because the abnormality is determined by using the change amount of a current as a standard.

The control unit 9 supplies a control signal to a shutter driving unit 10. For example, the shutter driving unit 10 is a solenoidal coil and is connected to a shutter 10a for shielding the laser light from entering the photodiode 5.

For example, when detection sensitivity is decreased due to the failure etc. of the photodiode 5, the high speed APC circuit 11 or the low speed APC circuit 13 may raise the output to maintain a constant output. In this case, in such a manner that the laser light of the abnormal light intensity leaking out to the outside does not adversely affect a human body, the shutter driving unit 10 supplies a shutter driving signal ("shielding-unit driving signal" of the present invention) to the shutter 10a to drive the shutter 10a and shields the laser light.

The high speed APC circuit 11 ("first automatic light output control circuit" of the present invention) compares the detection light intensity from the amplifier 7 with the target light intensity from the control unit 9. Then, the high speed APC circuit 11 generates an LD driving signal ("driving signal" of the present invention) such that the light output intensity of the laser light becomes the target light intensity, and supplies the LD driving signal to the LD driver 17 via the switch circuit 15. Moreover, the high speed APC circuit 11 outputs a feedback signal to the control unit 9 in order to generate the LD driving signal. Herein, because the high speed APC circuit 11 has a smaller time constant as compared to the low speed APC circuit 13, the high speed APC circuit quickly reaches the target light intensity to be a steady state.

The low speed APC circuit 13 ("second automatic light output control circuit" of the present invention) compares the detection light intensity with the target light intensity similar to the high speed APC circuit 11, and generates an LD driving signal such that the light output intensity of the laser light becomes the target light intensity. Because the low speed APC circuit 13 has a larger time constant as compared to the high speed APC circuit 11, the low speed APC circuit requires time until reaching the target light intensity. For this reason, the low speed APC circuit 13 starts by receiving an initial signal of a driving signal (voltage value) corresponding to the target light intensity from the control unit 9.

The switch circuit 15 designates the high speed APC circuit 11 or the low speed APC circuit 13 based on the switch signal supplied from the control unit 9. Then, the switch circuit 15 supplies the LD driving signal output from the high speed APC circuit 11 or the low speed APC circuit 13 to the LD driver 17.

In addition, the switching between the high speed APC circuit 11 and the low speed APC circuit 13 is not limited to a hardware approach and thus may employ a software approach. For example, when the control unit 9 is CPU that receives a feedback signal to operate, the control unit can switch between the APC circuits as one process of the CPU without the switch circuit 15.

The LD driver 17 ("driving current generating unit" of present invention) generates a driving current for driving the laser diode 3 and outputs the driving current. The LD driver 17 generates a driving current in accordance with a voltage value input from the high speed APC circuit 11 or the low speed APC circuit 13.

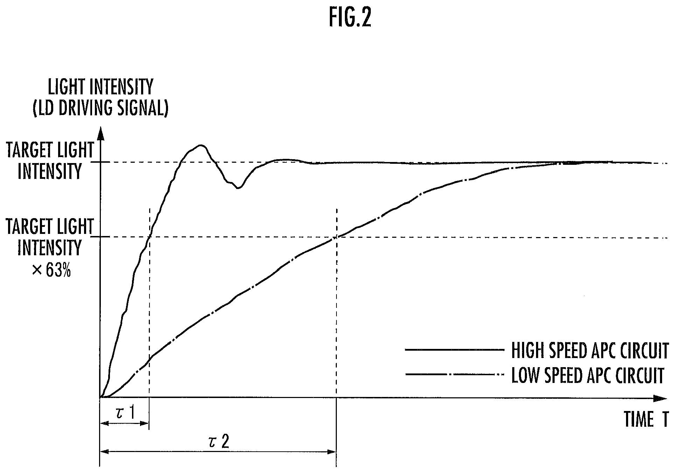

Next, circuit response characteristics of the high speed APC circuit 11 and the low speed APC circuit 13 will be explained with reference to FIG. 2.

The solid line in FIG. 2 illustrates a state in which the light intensity (LD driving signal) of the high speed APC circuit 11 rises when the high speed APC circuit 11 receives a signal on the detection light intensity from the amplifier 7. The target light intensity is standard output that is used by the light emission driving device 1.

In the high speed APC circuit 11, the rising of light intensity is steep, and the rising once exceeds the target light intensity and then gradually settles down in a stable state. Herein, a time from a point at which the high speed APC circuit 11 receives the signal of the detection light intensity to a point at which the intensity of the signal reaches the value of 63% of the target light intensity is regarded as a time constant τ1, but the time may be a time to a point at which the intensity of the signal reaches the value of the target light intensity.

On the other hand, the dashed-dotted line in FIG. 2 illustrates a state in which the light intensity (LD driving signal) raises when the low speed APC circuit 13 receives a signal on the detection light intensity from the amplifier 7. As illustrated in the drawing, in the low speed APC circuit 13, the rising of the light intensity is gentle as compared to the high speed APC circuit 11 and gradually settles down in a stable state without exceeding the target light intensity.

In addition, a time from a point at which the low speed APC circuit 13 receives the signal of the detection light intensity to a point at which the signal reaches the value of 63% of the target light intensity is a time constant τ2, and the time is four to five times longer than the time constant τ1.

The light emission driving device 1 according to the present invention makes good use of the special features of the high speed APC circuit 11 and the low speed APC circuit 13 to output laser light from the laser diode 3. For example, in case of an operation using the low speed APC circuit 13 at the time of startup of the light emission driving device 1, a time to reach the target light intensity becomes longer and thus the waiting time of a user who uses the light emission driving device 1 becomes longer. For this reason, the high speed APC circuit 11 is used at the time of startup of the light emission driving device 1.

Moreover, the light emission driving device 1 according to the present invention may be used for medical equipment such as a fundus camera, but the following problem may occur when the device is always operated by the high speed APC circuit 11. For example, when the sensitivity of the photodiode 5 that receives laser light is deteriorated, because the control unit 9 tries to raise the output of the laser diode 3, the light intensity of the laser light is immediately raised larger than the abnormal light intensity. Therefore, this laser light may leak out to the outside and reach the eyes of people.

Therefore, the light emission driving device 1 according to the present invention switches to the high speed APC circuit 11 to start and then switches to the operation of the low speed APC circuit 13 at the timing at which the predetermined time has passed after the light intensity is stable at the target light intensity. Because the light intensity is only slowly raised even when the photodiode 5 breaks down as described above, the low speed APC circuit 13 can be a device safer for a human body than the case where the device is operated by the high speed APC circuit 11.

Moreover, the output of laser light may be changed during the use of the light emission driving device 1. In such a case, the control unit once switches to the high speed APC circuit 11 and sets light intensity to a new target light intensity. Then, the control unit switches to the low speed APC circuit 13 at the timing at which the light intensity is stabilized at the new target light intensity. As a result, it is possible to suppress the waiting time of the user as much as possible and thus to cope with the failure of the photodiode 5 etc. at the time of subsequent use.

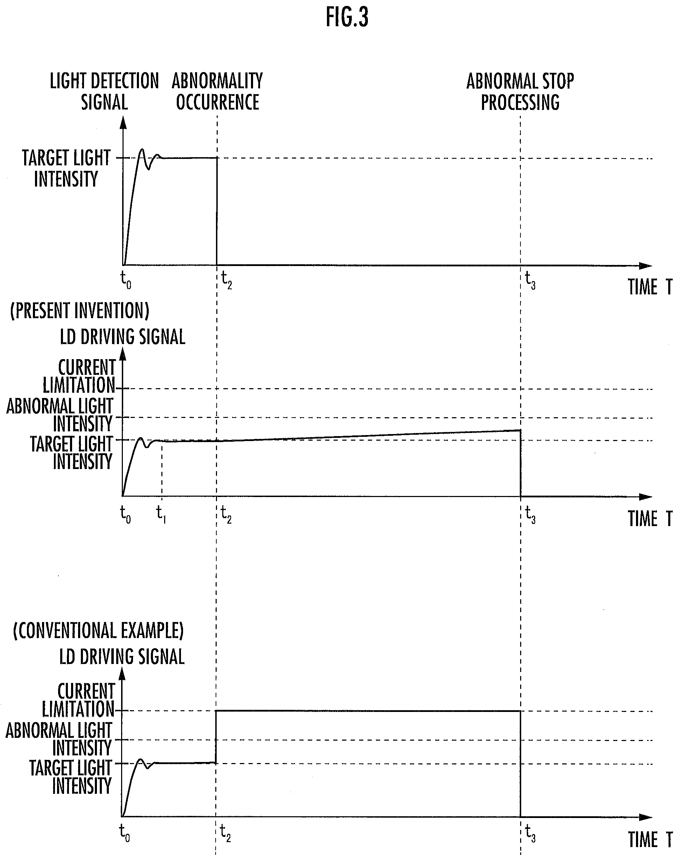

Finally, abnormal stop processing when an abnormality occurs in the photodiode 5 will be explained with reference to FIG. 3.

The change of the light detection signal of the photodiode 5 is illustrated as a graph in which the horizontal axis is a time "T" and the vertical axis is the light detection signal of the photodiode 5. It is assumed that the laser diode 3 is turned on at the time T=t₀ and, after the light detection signal reaches the level of the target light intensity, an abnormality occurs in the photodiode 5 at the time T=t₂. At this time, as illustrated in the drawing, the light detection signal is zero at the timing of the time T=t₂.

Moreover, the control of the light emission driving device 1 at this time is illustrated as a graph in which the horizontal axis is the time "T" and the vertical axis is the driving signal (LD driving signal) of the laser diode 3. First, the LD driving signal is gradually raised from the time T=t₀ and reaches the target light intensity before long. At this time, the light emission driving device 1 is driven by an operation by the high speed APC circuit 11. Then, the light emission driving device 1 switches to the low speed APC circuit 13 from the high speed APC circuit 11 by the switching signal from the control unit 9 at the time T=t₁ at which the LD driving signal is stabilized at the target light intensity. After that, the light emission driving device 1 is driven by an operation by the low speed APC circuit 13.

Then, when an abnormality occurs in the photodiode 5 at the time T=t₂, the low speed APC circuit 13 raises the LD driving signal of the laser diode 3 to constantly maintain a light intensity. However, because the operation by the low speed APC circuit 13 is currently performed, the light intensity is only slightly raised.

On the other hand, in the conventional example, when the operation by the high speed APC circuit 11 is performed to speed up startup and switching, the output of the laser diode 3 is suddenly raised at the time T=t₂. In other words, the conventional device reaches the current limitation of the laser diode 3 beyond the abnormal light intensity in a moment.

After that, it is assumed that the abnormal stop processing is performed at the time T=t₃. Because the abnormal stop processing according to the present invention is a mechanical method of driving the shutter 10a to shield the laser light, the period of the time T = t₂ to t₃ is short as approximately 20 ms. In this period, the amount of light that may adversely affect the human body is output in the conventional example, but the abnormal stop processing is completed before exceeding the abnormal light intensity in the present invention. Such the control is especially important when the light emission driving device 1 is applied to medical equipment such as a fundus camera and an optical coherence tomography.

In the light emission driving device 1, even when the supply of power to the shutter 10a is temporarily stopped due to the failure of an electric system, the shutter 10a automatically moves by a spring to the position at which the laser light is blocked. For this reason, the light emission driving device 1 can be said as an extremely safe device. The abnormal stop processing according to the present embodiment is the mechanical method of driving the shutter 10a, but the present embodiment is not limited to this. For example, the abnormal stop processing may stop the output of the laser diode 3 by turning off in circuit mode.

As described above, the light emission driving device 1 according to the present invention includes the high speed APC circuit 11 that has the time constant τ1 to reach the target light intensity and the low speed APC circuit 13 that has the time constant τ2 (> the time constant τ1) to reach the target light intensity. The control unit 9 operates the light emission driving device 1 by the high speed APC circuit 11 at the time of startup thereof, and after the light intensity of the laser light reaches the target light intensity and is stabilized, switches to the low speed APC circuit 13 and then generates a driving signal by the low speed APC circuit 13. As a result, it is possible to increase the safety of the light emission driving device.

The above embodiment is only an example, and thus can be appropriately changed depending on the application. For example, the response speed of the APC circuits is not limited to two kinds. Therefore, the response speed may be three kinds of the high speed, medium speed, and low speed. Such the light emission driving device may use the high speed APC circuit at the time of driving and switch to the medium speed APC circuit or the low speed APC circuit at the timing at which the light intensity reaches the target light intensity and is stabilized. Moreover, such the light emission driving device may use the low speed APC circuit in normal times and use the medium speed APC circuit when switching to a new target light intensity.

Moreover, the shutter driving unit 10 according to the present invention is a solenoidal coil, but the present invention is not limited to this. A motor may drive the shutter 10a or a shielding member to shield light by combining a plurality of sheets used in a camera etc. may be used.

### Description of Reference Numerals

1 ... light emission driving device, 3 ... laser diode, 5 ... photodiode, 7 ... amplifier, 9 ... control unit, 9a ... stability determining unit, 10 ... shutter driving unit, 10a ... shutter, 11 ... high speed APC circuit, 13 ... low speed APC circuit, 15 ... switch circuit, 17 ... LD driver.

## Claims

1. A light emission driving device comprising:
a light emitting unit;
a driving current generating unit configured to supply a driving current according to a driving signal to the light emitting unit;
a light detecting unit configured to detect emitted light from the light emitting unit;
a first automatic light output control circuit and a second automatic light output control circuit configured to adjust the driving signal to the driving current generating unit in accordance with a detection light intensity of the light detecting unit and to control an intensity of the emitted light to a predetermined target light intensity;
a circuit switching unit configured to switch between the first automatic light output control circuit and the second automatic light output control circuit in response to a switching signal; and
a control unit configured to instruct the first automatic light output control circuit and the second automatic light output control circuit to reach the target light intensity, wherein
the first automatic light output control circuit has a first time constant to reach the target light intensity,
the second automatic light output control circuit has a second time constant larger than the first time constant to reach the target light intensity, and
the control unit:
switches to the first automatic light output control circuit by the circuit switching unit at startup; and
when a predetermined time has passed after the intensity of the emitted light has reached the target light intensity, switches to the second automatic light output control circuit by the circuit switching unit and supplies an initial signal causing the second automatic light output control circuit to output the driving signal corresponding to the target light intensity.

2. The light emission driving device according to claim 1, further comprising:
a shielding unit configured to block the emitted light; and
a shielding drive unit configured to drive the shielding unit by being controlled by the control unit, wherein
the control unit supplies a shielding-unit driving signal to drive the shielding unit to the shielding drive unit when the detection light intensity of the light detecting unit is equal to or more than an abnormal light intensity higher than the target light intensity.

3. The light emission driving device according to claim 1, wherein
the light emission driving device includes a switch circuit as the circuit switching unit, and
the control unit supplies the switching signal to the switch circuit when switching between the first automatic light output control circuit and the second automatic light output control circuit.

4. The light emission driving device according to claim 3, wherein the control unit supplies the switching signal designating the first automatic light output control circuit to the switch circuit in response to a reception of a change signal to change the target light intensity after the predetermined time has passed.

5. A driving method of a light emission driving device that includes a light emitting unit, a light detecting unit configured to detect emitted light from the light emitting unit, and a drive control unit configured to adjust a driving signal to drive the light emitting unit in accordance with a detection light intensity of the light detecting unit and to control an intensity of the emitted light to a predetermined target light intensity,
the driving method comprising:
a first automatic light output control step of controlling the intensity of the emitted light to the target light intensity by using a first time constant; and
a second automatic light output control step of controlling the intensity of the emitted light to the target light intensity by using a second time constant larger than the first time constant after the first automatic light output control step, wherein
the second automatic light output control step starts driving from a light intensity corresponding to the target light intensity.

6. The driving method of the light emission driving device according to claim 5, further comprising:
a switching step of performing the first automatic light output control step in response to a change signal to change the target light intensity.
